# EUROPEAN PATENT APPLICATION

(11) **EP 3 288 360 A1**
(43) Date of publication of application: **28.02.2018**
(21) Application number: 17187001.7
(22) Date of filing: 21.08.2017
(51) Int. Cl.: H05K 7/20, H01L 23/40

(54) **CIRCUIT MODULE**

(30) Priority: 22.08.2016 JP 2016161867
(71) Applicant: Alps Electric Co., Ltd., Tokyo 145-8501 (JP)
(72) Inventor: SAITO, Tatsuo, Ota-ku, Tokyo 145-8501 (JP)
(74) Representative: Schmitt-Nilson Schraud Waibel Wohlfrom Patentanwälte Partnerschaft mbB

(57) **Abstract**

A circuit module (100) includes a circuit board (30) on a first surface (30a) of which electronic components (41) including at least one heat generating component (41a) are mounted, a plate member (10) attached to the first surface (30a) of the circuit board (30) so as to cover the heat generating component (41a), and a cover member (15) made of metal provided so as to face a second surface (30b) of the circuit board (30). The plate member (10) includes a plane portion (10a) that extends so as to face the heat generating component (41a), and leg portions (10c) that extend from the outer periphery of the plane portion (10a), pass through the circuit board (30), protrude to the second surface (30b) side of the circuit board (30), and are connected to the cover member (15).

## Description

The present invention relates to a circuit module, and more specifically, it relates to a circuit module on which a heat generating component is mounted.

There have been circuit modules in which a heat generating component is mounted. For example, in a circuit module having a communication function, a communication integrated circuit is mounted. In the case of a communication integrated circuit, since transmission power is required, power consumption is large, and heat is generated. Therefore, it is necessary to radiate the heat generated from this integrated circuit, that is, heat generating component in order to cause the heat generating component to operate normally. Various heat radiating structures have been developed for this heat radiation. For example, a heat radiating structure is known in which, on the lower surface of a circuit board, part of a housing such as a cover member is deformed, and heat is radiated to the housing side.

An electronic control unit 900 having such a heat radiating structure is disclosed in JP 2006-054481 A. The electronic control unit 900 will be described below with reference to Fig. 7.

In the electronic control unit 900, a printed board 979 is sandwiched between a case 935 and a cover 971 and is fixed to a housing with screws that pass through the printed board 979. Thermally conductive thin film layers made of copper foil are formed in parallel on a mounting surface and an opposite mounting surface 979b of the printed board 979 and inside the printed board 979, and these layers are thermally separated from each other. The cover 971 is provided with a protrusion 973 that protrudes from the bottom of the cover 971 toward the mounting position of an electronic component 925 that is a heat generating component. A flexible thermally conductive material 975 is disposed between the top surface 973a of the protrusion 973 and the opposite mounting surface 979b of the printed board 979 corresponding to the mounting position of the electronic component 925 (that is, the projection region of the electronic component 925). A movement-preventing portion 977 for effectively preventing a thermally conductive material 975 from flowing out is provided around the top surface 973a of the protrusion 973.

In the electronic control unit 900, by such a heat radiating structure, heat generated from the electronic component 925 is radiated through the printed board 979 to the cover 971.

In general, a heat generating component generates heat from both upper and lower surfaces thereof. However, in the case of a heat radiating structure such as that of the electronic control unit 900, since heat can be radiated only on the lower surface side of the heat generating component, sufficient heat radiation performance cannot be obtained. It is possible to provide a similar heat radiating structure on the upper surface side of the heat generating component. However, when the heat generating component has a different shape, it is necessary to change the shape and/or dimensions of the housing such as the case according to the shape of the heat generating component, and the housing cannot be standardized.

The present invention provides a circuit module that has improved heat radiation performance and that permits the standardization of the housing.

In an aspect of the present invention, a circuit module includes a circuit board on a first surface of which electronic components including at least one heat generating component are mounted, a plate member attached to the first surface of the circuit board so as to cover the heat generating component, and a cover member made of metal provided so as to face a second surface of the circuit board. The plate member includes a plane portion that extends so as to face the heat generating component, and leg portions that extend from the outer periphery of the plane portion, pass through the circuit board, protrude to the second surface side of the circuit board, and are connected to the cover member.

With this configuration, since heat on the upper surface side of the heat generating component is radiated through the plane portion and the leg portions of the plate member to the cover member, heat radiation performance can be improved. When the heat generating component has a different shape, it is only necessary to change the dimensions of each part of the plate member according to the shape of the heat generating component, and therefore the change in the shape and dimensions of the housing such as the case is not required. Therefore, the housing can be standardized while maintaining heat radiation performance.

It is preferable that the second surface of the circuit board be provided with a first pattern land disposed at a position corresponding to the heat generating component, that the cover member be provided with a protruding portion that protrudes toward the circuit board at a position corresponding to the first pattern land, and that a first heat radiating member be disposed between the protruding portion and the first pattern land.

With this configuration, since heat on the lower surface side of the heat generating component is radiated through the first pattern land of the circuit board and the first heat radiating member to the cover member, heat radiation performance can be further improved.

It is preferable that the second surface of the circuit board be provided with second pattern lands disposed at positions corresponding to the leg portions, and the first pattern land and the second pattern lands be connected, that a second heat radiating member be disposed between the plane portion and the heat generating component, and that the leg portions be connected to the second pattern lands and the protruding portion.

With this configuration, since heat on the upper surface side of the heat generating component is transferred through the second heat radiating member to the plane portion of the plate member, heat radiation performance can be improved. Since the leg portions are connected to the protruding portion of the cover member and are connected to the second pattern lands of the circuit board, heat on the upper surface side of the heat generating component can be radiated through the first pattern land connected to the second pattern lands and the first heat radiating member to the cover member. Therefore, heat radiation performance can be further improved.

It is preferable that the first heat radiating member and the second heat radiating member be both formed of silicone grease.

With this configuration, since the first heat radiating member and the second heat radiating member are both formed of silicone grease, the distance between the circuit board and the protruding portion of the cover member and the distance between the heat generating component and the plane portion of the plate member can be reduced compared to the case where the first heat radiating member and the second heat radiating member are silicone sheets, while filling the gap between the circuit board and the protruding portion of the cover member and the gap between the heat generating component and the plane portion of the plate member. Therefore, heat can be transferred more easily.

It is preferable that the plane portion be provided with an opening.

With this configuration, since the plane portion of the plate member is provided with the opening, silicone grease can be filled through the opening, and the check of the application of silicone grease and the control of the amount of application can be easily performed.

It is preferable that the plate member be formed of metal.

With this configuration, by forming the plate member of a highly thermally conductive metal such as copper or iron, heat can be transferred more easily.

It is preferable that the leg portions be provided at a plurality of places so as to surround the heat generating component.

With this configuration, since the leg portions are provided at a plurality of places, the plate member can be stably attached, and heat transferred to the plate member can be equally transferred to the leg portions. Therefore, heat can be radiated efficiently.
Fig. 1 is a perspective view showing the appearance of a circuit module according to an embodiment of the present invention;
Fig. 2 is a plan view of the circuit module;
Fig. 3 is an exploded perspective view showing main components of the circuit module;
Fig. 4 is a plan view of the lower surface of a circuit board;
Fig. 5 is an enlarged perspective view showing the appearance of the heat radiating structure of the circuit module;
Fig. 6 is an enlarged sectional view showing the heat radiating structure of the circuit module; and

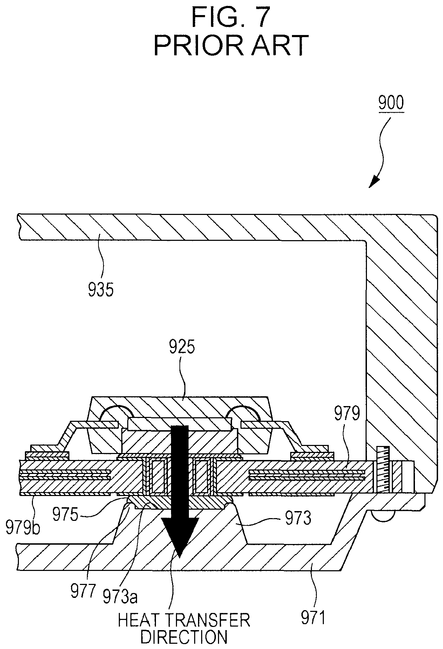

Fig. 7 is a sectional view of an electronic control unit relating to a conventional example.

A circuit module according to aspects of the present invention will be described below with reference to the drawings. The circuit module of the present invention is, for example, a small circuit module having a communication circuit used in wireless LAN (Local Area Network), Bluetooth (trademark), or the like, and is mounted and used in an electronic device such as a smartphone. The use of the circuit module of the present invention is not limited to the embodiment described below, and can be appropriately changed. In this specification, in the description with reference to the drawings, the words "right," "left," "rear," front," "upper," and "lower" respectively designate the +X side, -X side, +Y side, -Y side, +Z side, and -Z side in the drawings. Embodiment

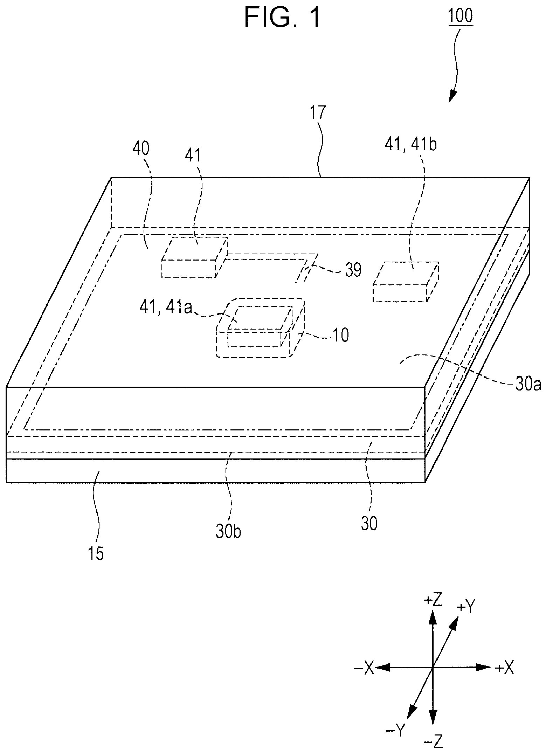

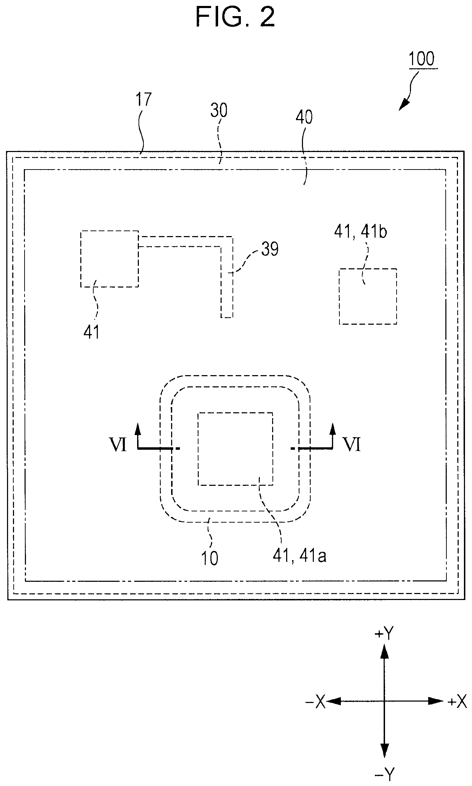

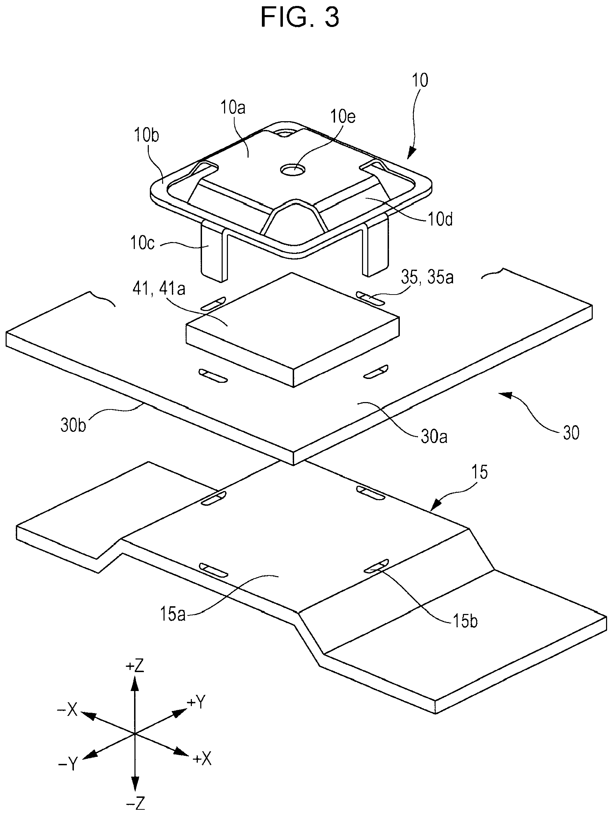

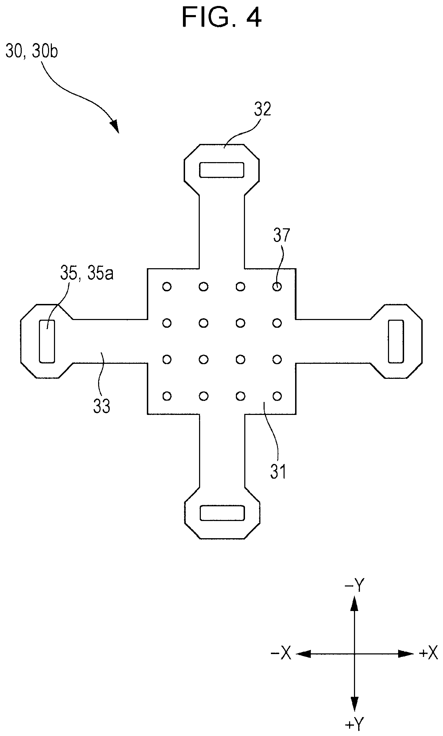

First, an outline of the structure of a circuit module 100 according to an embodiment of the present invention and main components of the circuit module 100 will be described with reference to Figs. 1 to 4. Fig. 1 is a perspective view showing the appearance of the circuit module 100, and Fig. 2 is a plan view of the circuit module 100. Fig. 3 is an exploded perspective view showing main components of the circuit module 100, and Fig. 4 is a plan view of the lower surface (second surface 30b) of a circuit board 30.

As shown in Figs. 1 and 2, the circuit module 100 includes a circuit board 30 that has a first surface 30a (upper surface) and a second surface 30b (lower surface) and has a rectangular shape, a case 17 that serves as a housing that houses the circuit board 30, and a cover member 15 that is provided so as to face the second surface 30b of the circuit board 30 and that is made of metal.

Electronic components 41 including at least one heat generating component 41a and a non-heat generating component 41b are mounted on the first surface 30a of the circuit board 30. The heat generating component 41a is, for example, a communication integrated circuit, and has a low cuboid shape that is square in plan view. The shape of the heat generating component 41a is not limited to a square shape, and may be, for example, a rectangular shape. A wiring pattern 39 is formed on the circuit board 30, and the wiring pattern 39 and the plurality of electronic components 41 form an electronic circuit 40.

A plate member 10 is attached to the first surface 30a of the circuit board 30 so as to cover the above-described heat generating component 41a. The plate member 10 is attached in order to transfer heat generated from the heat generating component 41a to the cover member 15 made of metal.

As shown in Fig. 3, the plate member 10 includes a plane portion 10a that extends so as to face the heat generating component 41a that is square in plan view, a frame portion 10b that is formed so as to surround the plane portion 10a and that is substantially square in plan view, connecting portions 10d that connect the plane portion 10a and the frame portion 10b, and leg portions 10c that extend from the outer periphery of the plane portion 10a through the connecting portions 10d and the frame portion 10b. An opening 10e that is circular in plan view is formed in the center of the plane portion 10a. The shape of the frame portion 10b is not limited to a substantially square shape, and may be, for example, a substantially rectangular shape.

The leg portions 10c of the plate member 10 are provided at a plurality of places so as to surround the heat generating component 41a, and are formed so as to extend downward. In the circuit module 100, the leg portions 10c are provided one in the center of each side of the substantially square frame portion 10b.

The height of the plane portion 10a from the frame portion 10b corresponds to the vertical height of the heat generating component 41a, and the dimensions of the frame portion 10b in the left-right direction and the front-rear direction correspond to the width and the depth of the heat generating component 41a. The length of the leg portions 10c corresponds to the thickness of the circuit board 30 and the thickness of the protruding portion 15a of the cover member 15. That is, the plate member 10 can be formed easily corresponding to the size of the heat generating component 41a and the thicknesses of the circuit board 30 and the cover member 15.

The plate member 10 is formed of metal, for example, a highly thermally conductive, easily punchable and bendable, and solderable metal such as copper or iron. The plate member 10 may be formed of a highly thermally conductive material other than metal, such as ceramic. When the plate member 10 is formed of metal, processing such as providing the leg portions 10c is easy.

The circuit board 30 has, at positions corresponding to the plurality of leg portions 10c of the plate member 10, a plurality of attachment holes 35 into which the plurality of leg portions 10c are inserted and attached. The attachment holes 35 are formed so as to function also as via holes 35a for electrically connecting the first surface 30a and the second surface 30b of the circuit board 30.

As shown in Fig. 4, the second surface 30b of the circuit board 30 is provided with a first pattern land 31 disposed at a position corresponding to the heat generating component 41a, and second pattern lands 32 disposed at positions corresponding to the leg portions 10c of the plate member 10. The first pattern land 31 and the second pattern lands 32 are connected by connecting pattern lands 33.

The first pattern land 31 is formed on the second surface 30b of the circuit board 30, according to the shape and area of the heat generating component 41a. In the circuit module 100, the first pattern land 31 is formed in a square shape in plan view according to the shape of the heat generating component 41a. The first pattern land 31 is provided with a plurality of via holes 37 for electrically connecting the first surface 30a and the second surface 30b of the circuit board 30. By providing the plurality of via holes 37 in the first pattern land 31, heat generated from the heat generating component 41a can be transferred from the first surface 30a to the second surface 30b of the circuit board 30.

The second pattern lands 32 are provided so as to surround the above-described attachment holes 35, and are formed in such a size that the leg portions 10c of the plate member 10 can be reliably attached to them by soldering.

The connecting pattern lands 33 are provided to connect the first pattern land 31 and the second pattern lands 32. When the size of the first pattern land 31 is set large, the first pattern land 31 and the second pattern lands 32 may be provided so as to be directly in contact with each other without the interposition of the connecting pattern lands 33 therebetween.

As with the plate member 10, the cover member 15 is formed of metal, for example, a highly thermally conductive metal such as cupper, iron, or aluminum. The cover member 15 forms the housing together with the case 17. As shown in Fig. 3, the cover member 15 is provided with a protruding portion 15a that protrudes toward the circuit board 30 at a position corresponding to the first pattern land 31 of the circuit board 30. The upper surface of the protruding portion 15a is flat, and is formed so as to be parallel to the second surface 30b of the circuit board 30.

The protruding portion 15a of the cover member 15 is provided with a plurality of connection holes 15b. The connection holes 15b are formed at a plurality of (four) positions corresponding to the attachment holes 35 provided in the circuit board 30, for inserting the leg portions 10c of the plate member 10.

The portion other than the protruding portion 15a of the cover member 15 is formed parallel to the circuit board 30, is the same size as the case 17, and is formed so as to cover the second surface 30b of the circuit board 30 as shown in Fig. 1.

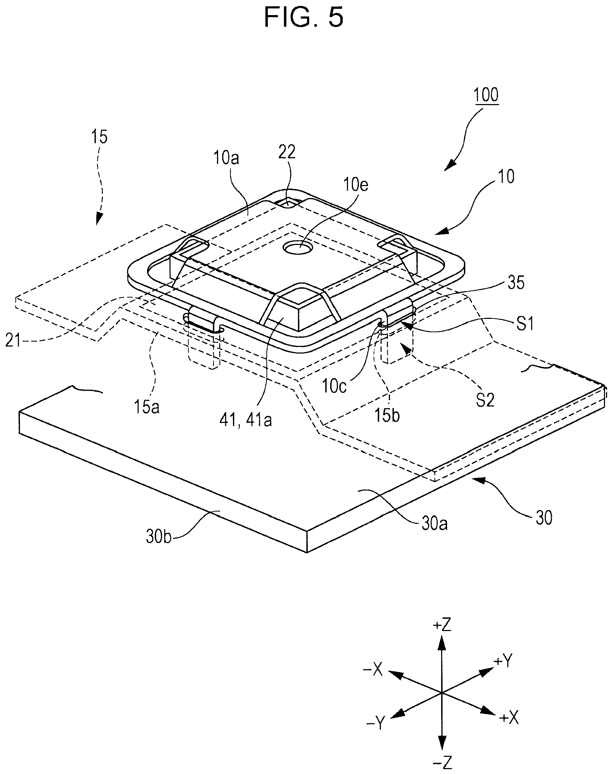

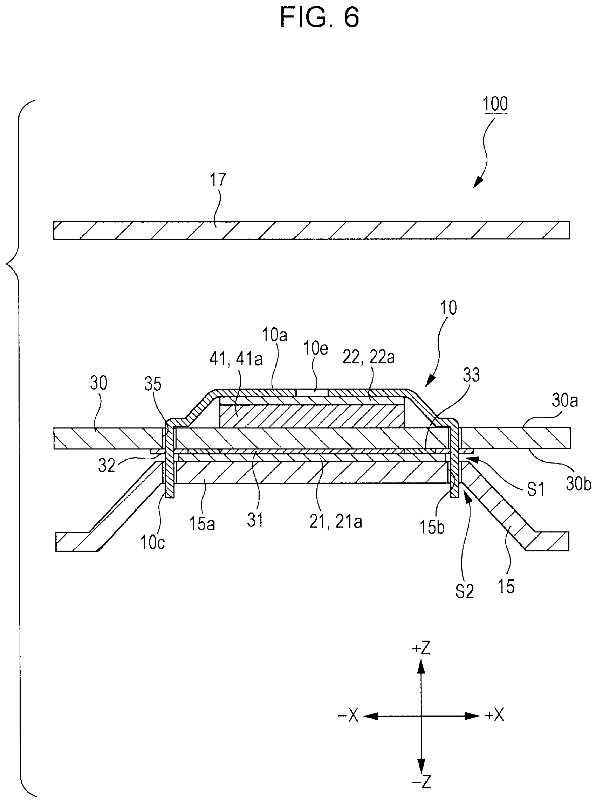

Next, the heat radiating structure in the circuit module 100 will be described with reference to Figs. 5 and 6. Fig. 5 is an enlarged perspective view showing the appearance of the heat radiating structure of the circuit module 100, and Fig. 6 is an enlarged sectional view showing the heat radiating structure of the circuit module 100 as seen from line VI-VI of Fig. 2.

The heat radiating structure for the heat generating component 41a in the circuit module 100 includes the plate member 10, the circuit board 30, the cover member 15, a first heat radiating member 21, and a second heat radiating member 22 as shown in Figs. 5 and 6.

The heat generating component 41a is mounted on the first surface 30a of the circuit board 30. The plate member 10 is attached to the circuit board 30 so as to cover the heat generating component 41a. The plane portion 10a of the plate member 10 is located over the upper surface of the heat generating component 41a, and the plurality of leg portions 10c are inserted into the attachment holes 35 of the circuit board 30 and are connected to the circuit board 30.

As shown in Fig. 6, the second heat radiating member 22 is disposed between the lower surface of the plane portion 10a of the plate member 10 and the upper surface of the heat generating component 41a. The second heat radiating member 22 is formed of silicone grease 22a, and is provided in close contact with each of the lower surface of the plane portion 10a of the plate member 10 and the upper surface of the heat generating component 41a. The second heat radiating member 22 may not be formed of silicone grease 22a but may be a silicone sheet. By forming the second heat radiating member 22 of silicone grease 22a, the distance between the plane portion 10a of the plate member 10 and the heat generating component 41a can be reduced, and heat radiation performance can be further improved.

Silicone grease 22a forming the second heat radiating member 22 is filled through the opening 10e of the plate member 10. When the plate member 10 is attached to the first surface 30a of the circuit board 30, a predetermined gap is provided between the plane portion 10a of the plate member 10 and the upper surface of the heat generating component 41a. After the attachment of the heat generating component 41a and the plate member 10 to the circuit board 30, silicone grease 22a is filled into the gap through the opening 10e of the plate member 10.

By disposing the second heat radiating member 22 formed of silicone grease 22a between the plane portion 10a of the plate member 10 and the upper surface of the heat generating component 41a, and filling the gap between the plane portion 10a of the plate member 10 and the upper surface of the heat generating component 41a, heat from the upper surface of the heat generating component 41a can be efficiently transferred to the plate member 10.

The gap between the circuit board 30 and the protruding portion 15a of the cover member 15, and the gap between the heat generating component 41a and the plane portion 10a of the plate member 10 are for absorbing the variation in dimensions and the variation in attachment position of each member. When these variations are very small, and the protruding portion 15a of the cover member 15 and the first pattern land 31 of the circuit board 30 can be brought into close contact with each other, the first heat radiating member 21 may not be necessary. Likewise, when the plane portion 10a of the plate member 10 and the upper surface of the heat generating component 41a can be brought into close contact with each other, the second heat radiating member 22 may not be necessary.

The plurality of leg portions 10c are connected to the second pattern lands 32 of the circuit board 30 by soldering at first connecting places S1 shown in Fig. 6. As a result, heat from the heat generating component 41a can be transferred through the second pattern lands 32 and the connecting pattern lands 33 of the circuit board 30 to the first pattern land 31.

As shown in Figs. 5 and 6, the cover member 15 made of metal is provided so as to face the second surface 30b of the circuit board 30. The plurality of leg portions 10c pass through the circuit board 30, protrude to the second surface 30b side of the circuit board 30, and are connected to the protruding portion 15a of the cover member 15.

The leg portions 10c are connected to the protruding portion 15a of the cover member 15 at second connecting places S2 in the connection holes 15b of the cover member 15 shown in Fig. 6. When the cover member 15 is formed of a solderable metal such as copper or iron, the leg portions 10c are connected to the cover member 15 by soldering.

When the cover member 15 is formed of aluminum, since soldering cannot be performed, the leg portions 10c are connected to the cover member 15 by press-fitting the leg portions 10c into the connection holes 15b or bringing the leg portions 10c into strong contact with the cover member 15 by caulking the leg portions 10c.

Even when the cover member 15 is formed of a metal such as copper or iron, the leg portions 10c may be connected to the cover member 15 by press-fitting the leg portions 10c into the connection holes 15b or caulking the leg portions 10c. Alternatively, the leg portions 10c may be connected to the cover member 15 by filling silicone grease into the connection holes 15b of the cover member 15 in which the leg portions 10c are inserted.

By connecting the plurality of leg portions 10c to the cover member 15, heat from the upper surface of the heat generating component 41a can be easily transferred through the plate member 10 to the cover member 15.

As shown in Fig. 6, the first heat radiating member 21 is disposed between the protruding portion 15a of the cover member 15 and the first pattern land 31 of the circuit board 30. As with the second heat radiating member 22, the first heat radiating member 21 is formed of silicone grease 21a, is provided in close contact with each of the upper surface of the protruding portion 15a of the cover member 15 and the first pattern land 31 of the circuit board 30, and fills the gap between the protruding portion 15a of the cover member 15 and the first pattern land 31 of the circuit board 30.

As with the second heat radiating member 22, the first heat radiating member 21 may not be formed of silicone grease 21a but may be a silicone sheet. By forming the first heat radiating member 21 of silicone grease 21a, the distance between the protruding portion 15a of the cover member 15 and the first pattern land 31 of the circuit board 30 can be reduced, and heat radiation performance can be further improved.

By disposing the first heat radiating member 21 between the protruding portion 15a of the cover member 15 and the first pattern land 31 of the circuit board 30, heat transferred from the lower surface of the heat generating component 41a through the circuit board 30 and the first pattern land 31, and heat transferred from the upper surface of the heat generating component 41a through the plate member 10 and the first pattern land 31 can be efficiently transferred to the cover member 15.

The advantageous effects of this embodiment will be described below.

In the circuit module 100, since heat on the upper surface side of the heat generating component 41a is radiated through the plane portion 10a and the leg portions 10c of the plate member 10 to the cover member 15, heat radiation performance can be improved. When the heat generating component 41a has a different shape, it is only necessary to change the dimensions of each part of the plate member 10 according to the shape of the heat generating component 41a, and therefore the change in the shape and dimensions of the housing such as the case 17 is not required. Therefore, the housing can be standardized while maintaining heat radiation performance.

Since heat on the lower surface side of the heat generating component 41a is radiated through the first pattern land 31 of the circuit board 30 and the first heat radiating member 21 to the cover member 15, heat radiation performance can be further improved.

Since heat on the upper surface side of the heat generating component 41a is transferred through the second heat radiating member 22 to the plane portion 10a of the plate member 10, heat radiation performance can be improved. Since the leg portions 10c are connected to the protruding portion 15a of the cover member 15 and are connected to the second pattern lands 32 of the circuit board 30, heat on the upper surface side of the heat generating component 41a can be radiated through the first pattern land 31 connected to the second pattern lands 32 and the first heat radiating member 21 to the cover member 15. Therefore, heat radiation performance can be further improved.

Since the first heat radiating member 21 and the second heat radiating member 22 are formed of silicone grease 21a and silicone grease 22a, the distance between the circuit board 30 and the protruding portion 15a of the cover member 15 and the distance between the heat generating component 41a and the plane portion 10a of the plate member 10 can be reduced compared to the case where the first heat radiating member 21 and the second heat radiating member 22 are silicone sheets, while filling the gap between the circuit board 30 and the protruding portion 15a of the cover member 15 and the gap between the heat generating component 41a and the plane portion 10a of the plate member 10. Therefore, heat can be transferred more easily.

Since the plane portion 10a of the plate member 10 is provided with the opening 10e, silicone grease 22a can be filled through the opening 10e, and the check of the application of silicone grease 22a and the control of the amount of application can be easily performed.

By forming the plate member 10 of a highly thermally conductive metal such as copper or iron, heat can be transferred more easily.

Since the leg portions 10c are provided at a plurality of places, the plate member 10 can be stably attached, and heat transferred to the plate member 10 can be equally transferred to the leg portions 10c. Therefore, heat can be radiated efficiently.

As described above, in the circuit module of the present invention, since heat on the upper surface side of the heat generating component is radiated through the plane portion and the leg portions of the plate member to the cover member, heat radiation performance can be improved. When the heat generating component has a different shape, it is only necessary to change the dimensions of each part of the plate member according to the shape of the heat generating component, and therefore the change in the shape and dimensions of the housing such as the case is not required. Therefore, the housing can be standardized while maintaining heat radiation performance.

The present invention is not limited to the above-described embodiment, and various changes may be made without departing from the spirit of the present invention.

## Claims

1. A circuit module (100) comprising:
a circuit board (30) on a first surface (30a) of which electronic components (41) including at least one heat generating component (41a) are mounted;
a plate member (10) attached to the first surface (30a) of the circuit board (30) so as to cover the heat generating component (41a); and
a cover member (15) made of metal provided so as to face a second surface (30b) of the circuit board (30),
wherein the plate member (10) includes a plane portion (10a) that extends so as to face the heat generating component (41a), and leg portions (10c) that extend from the outer periphery of the plane portion (10a), pass through the circuit board (30), protrude to the second surface (30b) side of the circuit board (30), and are connected to the cover member (15).

2. The circuit module (100) according to Claim 1,
wherein the second surface (30b) of the circuit board (30) is provided with a first pattern land (31) disposed at a position corresponding to the heat generating component (41a),
wherein the cover member (15) is provided with a protruding portion (15a) that protrudes toward the circuit board (30) at a position corresponding to the first pattern land (31), and
wherein a first heat radiating member (21) is disposed between the protruding portion (15a) and the first pattern land (31).

3. The circuit module (100) according to Claim 2,
wherein the second surface (30b) of the circuit board (30) is provided with second pattern lands (32) disposed at positions corresponding to the leg portions (10c), and the first pattern land (31) and the second pattern lands (32) are connected,
wherein a second heat radiating member (22) is disposed between the plane portion (10a) and the heat generating component (41a), and
wherein the leg portions (10c) are connected to the second pattern lands (32) and the protruding portion (15a).

4. The circuit module (100) according to Claim 3, wherein the first heat radiating member (21) and the second heat radiating member (22) are both formed of silicone grease (21a, 22a).

5. The circuit module (100) according to one of Claims 1-4, wherein the plane portion (10a) is provided with an opening (10e).

6. The circuit module (100) according to one of Claims 1-5, wherein the plate member (10) is formed of metal.

7. The circuit module (100) according to one of Claims 1-6, wherein the leg portions (10c) are provided at a plurality of places so as to surround the heat generating component (41a).
